# EUROPEAN PATENT APPLICATION

(11) **EP 4 438 656 A1**
(43) Date of publication of application: **02.10.2024**
(21) Application number: 24163502.8
(22) Date of filing: 14.03.2024
(51) Int. Cl.: C08G 73/10, C08G 73/16, H05K 1/00

(54) **POLYAMIC ACID, POLYAMIC ACID COMPOSITION, POLYIMIDE, POLYIMIDE FILM, AND PRINTED CIRCUIT BOARD**

(30) Priority: 27.03.2023 JP 2023050564
(71) Applicant: Tamura Corporation, Tokyo 178-8511 (JP)
(72) Inventor: HORI, Atsushi, Iruma-shi, Saitama (JP); ENDO, Taiki, Iruma-shi, Saitama (JP)
(74) Representative: Zacco GmbH

(57) **Abstract**

The present invention is related to providing a polyamic acid that can form a polyimide exhibiting a low dielectric property and a low hygroscopic property, and a polyamic acid composition, polyimide, polyimide film, and printed circuit board that are produced by using the polyamic acid. A polyamic acid that is a product obtained by polyaddition reaction between an ester-type acid dianhydride (A) and at least two diamines (B), wherein a dimer diamine (B1) is contained at a molar ratio of 0.3 or more relative to an entirety of the diamine component.

## Description

### Technical Field

The present invention relates to a polyamic acid that can form a polyimide exhibiting a low dielectric property and a low hygroscopic property, and a polyamic acid composition, polyimide, polyimide film, and printed circuit board that are produced by using this polyamic acid.

### Background Art

For insulative materials forming mobile telecommunication devices such as smartphones and tablets, and electronic devices such as computers and car navigation systems, high insulation breakdown voltage and heat resistance are required. A polyimide, which is an imidized polymer of a polyamic acid commonly synthesized from an acid dianhydride and an aromatic diamine compound, has excellent heat resistance, mechanical properties, and insulativity, and is therefore widely used for such insulative materials.

In recent years, a printed circuit board for high-speed large-capacity next-generation high-frequency wireless systems has been developed, and adopting a circuit substrate having a multilayer wiring structure enables high-speed transmission of signals. Polyimides are used for an interlayer insulative film in the multilayer wiring structure, but common polyimides have high dielectric properties such as dielectric constant, and thereby cause delays in the transmission of the signals to inhibit increase in the speed. Further, an electrostatic capacity increases with the high dielectric constant, and thereby wiring near the insulative film generates heat in use with high-speed telecommunication (high frequency), and causes malfunction and the like of the printed circuit board.

For a countermeasure of such high frequency, a demand for a polyimide exhibiting a low dielectric property has increased. For example, Patent Literature 1 discloses that a polyimide produced by using an aromatic diamine and tetracarboxylic dianhydride having specific structures exhibits a low dielectric constant and excellent heat resistance.

A known method is decreasing a concentration of imide groups by introducing a fluorene skeleton into a diamine component to decrease the polarity of an entire molecule, and reducing a dielectric constant of the polyimide. For example, Patent Literature 2 discloses that a polyimide using trimellitic anhydride chloride as an acid anhydride and 9,9-bis(4-aminophenyl)fluorene as a diamine exhibits high heat resistance and low specific dielectric constant.

Meanwhile, in polyimides in general, the imide group absorbs water easily, and dielectric properties vary significantly between a wet state and a dry state, and thereby the polyimide is required to exhibit the low dielectric property even under high humidity. Thus, it has been demanded to form a polyimide exhibiting not only the low dielectric property but also a low hygroscopic property.

### Document List

### Patent Literatures

Patent Literature 1: Japanese Patent Application Laid-Open No. H10-152559
Patent Literature 2: Japanese Patent Application Laid-Open No. 2005-298625

### Summary of Invention

### Technical Problem

It is an object of the present invention to provide a polyamic acid that can form a polyimide exhibiting a low dielectric property and a low hygroscopic property, and a polyamic acid composition, polyimide, polyimide film, and printed circuit board that are produced by using this polyamic acid.

### Solution to Problem

An aspect of the present invention is a polyamic acid that is a product obtained by polyaddition reaction between an ester-type acid dianhydride (A) and at least two diamines (B), wherein a dimer diamine (B1) is contained at a molar ratio of 0.3 or more relative to an entirety of the diamine component.

In an embodiment of the present invention, the ester-type acid dianhydride (A) has a structure represented by the following formula (1): 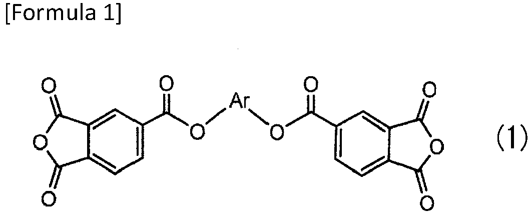 wherein Ar represents a substituted or unsubstituted arylene group.

In an embodiment of the present invention, the at least two diamines (B) comprise an aromatic diamine (B2).

Another aspect of the present invention is a polyamic acid composition comprising the above polyamic acid and an organic solvent (C).

Another aspect of the present invention is a polyimide obtained by imidizing the above polyamic acid.

Another aspect of the present invention is a polyimide film comprising the above polyimide.

Another aspect of the present invention is a printed circuit board comprising the above polyimide film.

### Effects of Invention

According to the present invention, the polyamic acid that can form a polyimide exhibiting the low dielectric property and the low hygroscopic property, and the polyamic acid composition, polyimide, polyimide film, and printed circuit board that are produced by using this polyamic acid can be provided.

### Description of Embodiments

Hereinafter, embodiments of the present invention will be described in detail. A polyamic acid of the present invention is a product obtained by polyaddition reaction between an ester-type acid dianhydride (A) and at least two diamines (B), wherein a dimer diamine (B1) is contained at a molar ratio of 0.3 or more relative to an entirety of the diamine component. That is, a polyimide formed by using the polyamic acid of the present invention has an ester skeleton and a dimer skeleton, and can achieve the low water-absorption property derived from the ester skeleton. In addition, the low dielectric property derived from the dimer skeleton is exhibited, and containing a predetermined amount of the dimer diamine as the diamine component can more reduce the dielectric constant and dielectric loss tangent and can achieve the desired low dielectric property. Further, the polyimide having the dimer skeleton improves the heat resistance, and can form the polyimide also having excellent pyrolysis resistance.

### (A) Ester-Type Acid Dianhydride

The polyamic acid of the present invention has a structural unit derived from the ester-type acid dianhydride having an ester bond in the molecule, as the acid dianhydride component. The polyamic acid having the structural unit derived from the ester-type acid dianhydride can impart the low water-absorption property to the obtained polyimide. The acid dianhydride, which has two acid anhydride groups in one molecule, is preferably a tetracarboxylic dianhydride, and more preferably an aromatic tetracarboxylic dianhydride. There may be one or more ester bonds in the molecule, preferably one to three, and more preferably one or two. One ester-type acid dianhydride may be used, or two or more thereof may be used in combination.

Such an ester-type acid dianhydride preferably has a structure represented by the following formula (1). In the formula (1), Ar represents a substituted or unsubstituted arylene group, and the substituted arylene group means that a hydrogen atom in the unsubstituted arylene group is substituted with a given substituent. The number of carbon atoms of the substituted or unsubstituted arylene group (excluding the number of carbon atoms of the substituent) is preferably 6 to 20, and more preferably 6 to 12.

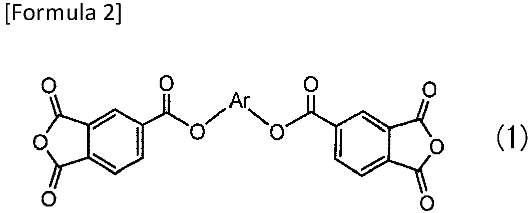

Examples of the unsubstituted arylene group for the group Ar include an o-phenylene group, a m-phenylene group, a p-phenylene group, a 2,6-naphthylene group, and a 4,4'-biphenylylene group. Among these groups, p-phenylene group, 2,6-naphthylene, and 4,4'-biphenylylene group are preferable.

Examples of the given substituent in the substituted arylene group include an alkyl group having 1 to 8 carbon atoms, a halogen atom (a fluorine atom, a chlorine atom, a bromine atom, and an iodine atom), and a halogenated alkyl group in which a hydrogen atom in the alkyl group is substituted with the halogen atom. Among these substituents, the alkyl group having 1 to 8 carbon atoms is preferable, and a methyl group is more preferable. The number of the given substituents may be one, or may be two or more. When two or more of the substituents are present, these substituents may be the same as or different from each other. Specific examples of the substituted arylene group include a 2,2',3,3',5,5'-hexamethyl-4,4'-biphenylylene group.

As the group Ar, a p-phenylene group, a 2,6-naphthylene group, a 4,4'-biphenylylene group, a methylphenylene group, and a 2,2',3,3',5,5'-hexamethyl-4,4'-biphenylylene group are preferable.

Preferable examples of the ester-type acid dianhydride represented by the formula (1) include a compound represented by the following formula (1-1) (TAHQ) and a compound represented by the following formula (1-2) (TMPBP-TME), and the compound represented by the following formula (1-2) is more preferable.

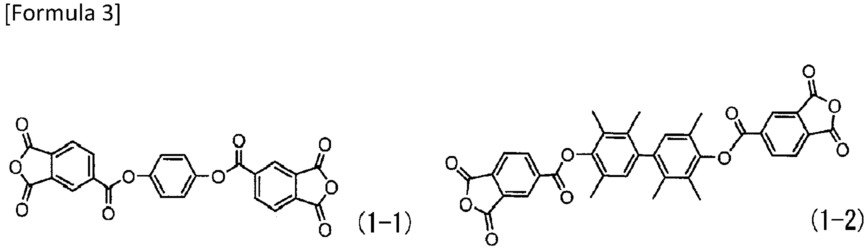

### (B) Diamine

The polyamic acid of the present invention has a structural unit derived from at least two diamines as the diamine component, and one of the diamine components has a structural unit derived from a dimer diamine (B1). Here, the dimer diamine means an aliphatic diamine in which two terminal carboxylic acid groups (-COOH) of a cyclic or acyclic dimer acid obtained as a dimer of an unsaturated fatty acid are substituted with a primary aminomethyl group (-CH₂-NH₂) or an amino group (-NH₂). The polyamic acid having the structural unit derived from the dimer diamine can impart the low dielectric property to the obtained polyimide. One dimer diamine may be used, or two or more thereof may be used in combination.

The dimer acid is a dibasic acid obtained by an intermolecular polymerization reaction of the unsaturated fatty acid. The aliphatic diamine derived from the dimer acid is obtained by: polymerizing the unsaturated fatty acid such as, for example, oleic acid, linoleic acid, and linolenic acid to form the dimer acid; and reducing and then aminating this dimer acid. Such a dimer diamine is preferably a diamine compound obtained by substituting terminal carboxylic acid groups of a dibasic acid compound having carbon atoms within a range of 18 to 54, preferably within a range of 22 to 44, with a primary aminomethyl group or an amino group.

Examples of commercial products of the dimer diamine include: "Versamine (R) 551" and "Versamine (R) 552", manufactured by Cognis Japan Ltd.; and "PRIAMINE (R) 1073", "PRIAMINE (R) 1074", and "PRIAMINE (R) 1075", manufactured by Croda Japan KK.

In the polyamic acid of the present invention, the dimer diamine (B1) is contained at a molar ratio of 0.3 or more relative to an entirety of the diamine component. The dimer diamine contained at the specific molar ratio or more relative to the entire diamine can impart a lower dielectric constant and lower dielectric loss tangent to the obtained polyimide. The molar ratio of the dimer diamine (B1) relative to the entirety of the diamine component is preferably 0.3 or more, and more preferably 0.4 or more.

The polyamic acid of the present invention may contain an aromatic diamine (B2) as another diamine component. Examples of the aromatic diamine include p-phenylenediamine (PDA), m-phenylenediamine, 4,4'-oxydianiline (ODA), 3,3'-bistrifluoromethyl-4,4'-diaminobiphenyl (TFMB), 3,4'-diaminodiphenyl ether, 4,4'-diaminodiphenylmethane, 3,3'-dimethyl-4,4'-diaminodiphenylmethane, 2,2-bis[4-(4-aminophenoxy)phenyl]propane, 1,2-bis(anilino)ethane, diaminodiphenyl sulfone, diaminobenzanilide, diaminobenzoate, diaminodiphenyl sulfide, 2,2-bis(p-aminophenyl)propane, 2,2-bis(p-aminophenyl)hexafluoropropane, 1,5-diaminonaphthalene, diaminotoluene, diaminobenzotrifluoride, 1,4-bis(p-aminophenoxy)benzene, 4,4'-bis(p-aminophenoxy)biphenyl, diaminoanthraquinone, and 4,4'-bis(3-aminophenoxy)diphenyl sulfone. Among these aromatic diamines, PDA, ODA, and TFMB are preferable, and ODA is more preferable. One aromatic diamine may be used, or two or more thereof may be used in combination.

A molar ratio of the diamine to the ester-type acid dianhydride [(B)/(A)] is not particularly limited, but is preferably 0.90 to 1.10, more preferably 0.95 to 1.05, further preferably 0.97 to 1.03, and particularly preferably 0.98 to 1.02.

### <Polyamic Acid and Polyamic Acid Composition>

### (C) Organic Solvent

The polyamic acid of the present invention can be synthesized by a known common method. For example, the ester-type acid dianhydride and the diamine are reacted in an organic solvent (C) to obtain a polyamic acid composition (polyamic acid solution). The organic solvent used for the polymerization of the polyamic acid is not particularly limited as long as the solvent can dissolve the ester-type acid dianhydride and the diamine as monomer components, and can dissolve the polyamic acid generated by the polyaddition reaction. Examples of such an organic solvent include: urea solvents such as tetramethylurea and N,N-dimethylethylurea; sulfone solvents such as dimethyl sulfoxide, diphenyl sulfone, and tetramethylsulfone; amide solvents such as N,N-dimethylacetamide, N,N-dimethylformamide, N,N-diethylacetamide, N-methyl-2-pyrrolidone, and hexamethylphosphoric triamide; ester solvents such as γ-butyrolactone; halogenated alkyl solvents such as chloroform and methylene chloride; aromatic hydrocarbon solvents such as benzene and toluene; phenol solvents such as phenol and cresol; ketone solvents such as cyclopentanone; and ether solvents such as tetrahydrofuran, 1,3-dioxolane, 1,4-dioxane, dimethyl ether, diethyl ether, and p-cresol methyl ether. These organic solvents may be used singly, or may be used in combinations of two or more thereof. From the viewpoint of improvement of solubility and reactivity of the polyamic acid, the organic solvent is preferably selected from the group consisting of the amide solvents, the ketone solvents, the ester solvents, and the ether solvents, and preferably the amide solvents such as N,N-dimethylacetamide, N,N-dimethylformamide, N,N'-diethylacetamide, and N-methyl-2-pyrrolidone.

Regulating a molar ratio between: the number of moles of the total amount of the ester-type acid dianhydride component; and the number of moles of the total amount of the diamine component can regulate a molecular weight of the polyamic acid. The molecular weight (weight-average molecular weight) of the polyamic acid is not particularly limited, but more preferably 10,000 or more and 100,000 or less from the viewpoint of solubility in the organic solvent. The weight-average molecular weight of the polyamic acid can be determined from a value in terms of standard polystyrene by gel permeation chromatography (GPC) measurement, for example.

The synthesis of the polyamic acid by the polyaddition reaction between the ester-type acid dianhydride and the diamine is preferably performed in an inert atmosphere such as argon and nitrogen. The polyaddition reaction proceeds by dissolving and mixing the ester-type acid dianhydride and the diamine in the organic solvent in the inert atmosphere. An addition order of the ester-type acid dianhydride and the diamine is not particularly limited. For example, the diamine may be dissolved or dispersed like a slurry in the organic solvent to form a diamine solution, and the ester-type acid dianhydride may be added into the diamine solution. The ester-type acid dianhydride and the diamine may be directly added into the organic solvent in a solid state, or may be added in a state where the ester-type acid dianhydride and the diamine are separately dissolved or dispersed like a slurry in the organic solvent.

A temperature condition of the polyaddition reaction is not particularly limited. The reaction temperature is preferably 100°C or lower from the viewpoint of inhibiting decrease in the molecular weight of the polyamic acid due to depolymerization, and the reaction temperature is more preferably 20 to 80°C from the viewpoint of appropriately progressing the polyaddition reaction. The reaction time is freely set within a range of 1 to 72 hours, and the resultant may be further left to stand overnight at room temperature as necessary.

A viscosity of the solution when the polyamic acid composition of the present invention is prepared is preferably 500 mPa·s or more from the viewpoint of film formability. A concentration of the polyamic acid in the polyamic acid composition of the present invention is preferably 10 mass% or more, more preferably 15 mass% or more, and further preferably 25 mass% or more. In particular, when the concentration of the polyamic acid is 15 mass% or more, productivity of forming a polyimide coating using the polyamic acid can be improved. An upper limit of the concentration of the polyamic acid is preferably 50 mass% or less, and further preferably 30 mass% or less from the viewpoint of sufficiently dissolving the polyamic acid in the organic solvent.

To impart processing properties and functionalities to the polyamic acid and the polyimide formed by using this polyamic acid, various organic or inorganic low-molecular-weight compound or polymer compound may be blended with the polyamic acid composition. For example, the polyamic acid composition may contain a dye, a surfactant, a leveling agent, a plasticizer, fine particles, a sensitizer, and a silane coupling agent. The fine particles may be any of organic fine particles and inorganic fine particles, and may have a porous or hollow structure.

### <Polyimide>

A method for converting the polyamic acid into the polyimide is not particularly limited, and the polyimide can be manufactured by dehydration and cyclization (imidization) of the polyamic acid obtained as described above. As the method for the dehydration and cyclization (imidization), known methods such as a thermal imidization of dehydration and cyclization by heating, a chemical imidization of chemical cyclization by using a known dehydration and cyclization catalyst, and the like can be adopted.

In a case of the thermal imidization, the heating temperature is preferably 120 to 350°C, and more preferably 150 to 250°C. The heating time is preferably 0.5 to 3 hours, and more preferably 1 to 2 hours. In a case of the chemical imidization, pyridine, triethylamine, acetic anhydride, and the like can be used as the dehydration and cyclization catalyst, for example. In this case, any temperature within 20 to 100°C can be selected as the reaction temperature. The temperature is preferably 50°C or lower, and the reaction time is preferably 1 to 3 hours. Although the imidization may be performed under air, under a reduced pressure, or in an inert gas such as nitrogen, the imidization is preferably performed under a reduced pressure or in an inert gas such as nitrogen to obtain a highly transparent polyimide film.

A molecular weight (weight-average molecular weight) of the polyimide is not particularly limited, but is preferably 10,000 or more and 100,000 or less from the viewpoint of the low dielectric property, the solubility in the organic solvent, and the film formability of the obtained polyimide. The weight-average molecular weight of the polyimide can be determined from a value in terms of standard polystyrene by gel permeation chromatography (GPC) measurement, for example.

### <Polyimide Film>

The polyimide film of the present invention contains the polyimide obtained above. A method for manufacturing such a polyimide film is not particularly limited, and examples of the method include: a method including applying the above polyamic acid composition onto a substrate (for example, a plastic film such as polyethylene, polypropylene, urethane, polyester, polyethylene terephthalate (PET), or polycarbonate, a glass plate, a stainless steel plate, a copper plate including a thin copper foil, an aluminum plate, or the like) in a film form, and then drying and heating the film to remove the solvent, and performing the dehydration and cyclization (imidization); and a method including dissolving the polyimide obtained by converting the polyamic acid into the polyimide in the organic solvent, applying the polyimide solution onto a substrate in a film form, and drying the film to remove the solvent. The method of application onto the substrate is not particularly limited, and conventionally known methods of application can be employed.

A thickness of the polyimide film is not particularly limited, and may be appropriately selected depending on the use. The thickness of the polyimide film is preferably 10 to 100 µm, and more preferably 20 to 50 µm. The thickness of the polyimide film can be easily controlled by appropriately regulating a solid-content concentration of each component in the polyamic acid composition, an application thickness, and the viscosity.

### <Printed circuit board>

The polyimide film of the present invention is suitably used as a film for members such as a color filter, a flexible display, a semiconductor component, and an optical component. Since the polyimide film exhibits insulativity, the polyimide film is suitably employed as an insulative substrate of a printed circuit board. In addition, since the polyimide film is an insulative, thin, and flexible film, the polyimide film is effectively employed as a base film of a bendable circuit substrate called flexible printed circuit (FPC).

### Example

Thereafter, Examples of the present invention will be described. However, the present invention is not limited to these examples as long as not departing from the spirit of the present invention.

### <Examples 1 to 2 and Comparative Examples 1 to 3>

An organic solvent in which an aromatic diamine shown in the following Table 1 was dissolved was fed into a separable flask at a blending ratio shown in the following Table 1, and then a dimer diamine and an acid dianhydride shown in the following Table 1 were fed in this order at a blending ratio shown in the following Table 1, and the obtained mixture was stirred at 50 to 80°C for 2 hours and further stirred at room temperature for 24 hours to prepare a polyamic acid composition used in Examples 1 to 2 and Comparative Examples 1 to 3. The prepared polyamic acid composition was applied onto a substrate by using a specimen-producing step, described later, to produce a specimen. By using the produced specimen, properties shown in the following Table 1 were each evaluated. Table 1 shows the evaluation results. Note that the blending amount of each component shown in the following Table 1 is represented on parts by mass unless otherwise mentioned.

**[Table 1]**

| Polyamic acid composition | | | Example 1 | Example 2 | Comparative Example 1 | Comparative Example 2 | Comparative Example 3 |
|---|---|---|---|---|---|---|---|
| (A) Acid dianhydride | (A1) Ester-type acid dianhydride | TMPBP-TME | 620 | 6.20 | | 620 | 6.20 |
| | (A2) Tetracarboxylic dianhydride | PMDA | | | 436 | | |
| (B) Diamine | (B1) Dimer diamine | PRIAMINE 1075 | 401 | 2.67 | 801 | 1 34 | |
| | (B2) Aromatic diamine | 4,4'-ODA | 0.50 | 1.00 | 1.00 | 150 | 400 |
| (C) Organic solvent | Amide solvent | NMP | 32.05 | 29.49 | 40.03 | 27.10 | 73.20 |
| Molar ratio of component (B) to component (A) | | | 1.00 | 1.00 | 1.00 | 1.00 | 1.00 |
| Molar ratio of component (B1) relative to total amount of component (B) | | | 0.75 | 0.50 | 0.75 | 025 | - |

| Evaluation of polyimide | | | Evaluation results | | | | |
|---|---|---|---|---|---|---|---|
| Dielectric property | Dielectric constant | | 1.89 | 2.31 | 2.23 | 2.44 | 2.96 |
| | Dielectric constant at 85°C, humidity of 85%, after 200 hours | | 1.94 | 2.11 | unmeasured | unmeasured | 2.99 |
| | Dielectric loss tangent | | 0.0014 | 0.0023 | 0.0028 | 0.0034 | 0.019 |
| | Dielectric loss tangent at 85°C, RH85°,6, after 200 hours | | 0.0014 | 0.0017 | unmeasured | unmeasured | 0.020 |
| Insulativity | Insulation breakdown voltage [kV/mm] | | 392 | 348 | 346 | 346 | 443 |
| Pyrolysis resistance | Td5 [°C] | | 390 | 345 | 319 | 368 | 241 |
| Mechanical strength | Elastic modulus [GPa] | | 0.33 | 1.25 | 0.35 | 1.80 | 2.70 |
| | Rupture strength [MPa] | | 20.3 | 80.5 | 24.5 | 120 | 140 |
| | Elongation [%] | | 220 | 102 | 207 | 69 | 7.7 |
| Water-absorption property | Water-absorption rate [%] | | 0.059 | 0.070 | 0.101 | unmeasured | unmeasured |

| | | | | | | | |
|---|---|---|---|---|---|---|---|
| [0047] Details of each component in Table 1 were as follows. (A1) Ester-Type Acid Dianhydride TMPBP-TME: manufactured by Honshu Chemical Industry Co., Ltd., 2,2',3,3',5,5'-hexamethyl[1,1'-biphenyl]-4,4'-diyl bis(1,3-dioxo-1,3-dihydro-2-benzofuran-5-carboxylate) (A2) Tetracarboxylic Dianhydride PMDA: pyromellitic dianhydride (B1) Dimer Diamine PRIAMINE (R) 1075: manufactured by Croda Japan KK, Dimer Diamine (B2) Aromatic Diamine 4,4'-ODA: 4,4'-oxydianiline (C) Organic Solvent NMP: N-methyl-2-pyrrolidone | | | | | | | |

### <Specimen-Producing Step>

A PET film ("Very-low Adhesion Sheet for Processing PET 75", manufactured by NEION Film Coatings Corp.: thickness 75 µm) as the substrate was surface-treated (defatting-treated) with isopropyl alcohol, and then each of the polyamic acid compositions prepared in Examples 1 to 2 and Comparative Examples 1 to 3 was applied onto this substrate by using a bar coater, and thereafter preliminary drying was performed at 80°C for 30 minutes. After the preliminary drying, post curing was performed at 150°C for 1 hour and 180°C for 30 minutes for thermal curing to form a cured coating (polyimide film) having a predetermined thickness on the substrate, and to produce the specimen.

### <Evaluations>

### (1) Dielectric Constant and Dielectric Loss Tangent

In the specimen-producing step, a specimen was produced so that the thickness of the cured coating was 30 µm ± 10 µm. Then, the obtained specimen was cut to have a length of 50 mm and a width of 2 mm to prepare a sample, and a dielectric constant and a dielectric loss tangent were each measured with a cavity resonance method by using a network analyzer and a cavity resonator manufactured by Keysight Technologies under conditions of measurement temperature of 25°C, measurement humidity of 50 RH%, and frequency of 10 GHz. A dielectric constant and a dielectric loss tangent at a frequency of 10 GHz after heating under an atmosphere of temperature of 85°C and humidity of 80 RH% for 200 hours were also each measured.

### (2) Elastic Modulus

In the specimen-producing step, a specimen was produced so that the thickness of the cured coating was 50 µm ± 10 µm. Then, the formed cured coating was peeled from the substrate and cut to a predetermined size to prepare a sample. By using an autograph manufactured by SHIMADZU CORPORATION, an elastic modulus was measured under a condition of tensile speed of 5 mm/min.

### (3) Elongation Rate and Rupture Strength

On a sample same as the sample produced for measuring the elastic modulus, an elongation rate and a rupture strength were each measured by using an autograph manufactured by SHIMADZU CORPORATION under a condition of tensile speed of 5 mm/min.

### (4) Water-Absorption Rate

In the specimen-producing step, a specimen was produced so that the thickness of the cured coating was 30 µm ± 10 µm. The obtained specimen was cut to 2 to 3 cm in square to prepare a sample. The sample was immersed in distilled water for 24 hours, the sample was taken out, and water on the surface was wiped off with rag. Thereafter, the sample was heated to 150°C, and a water-absorption rate was measured based on an amount of water generated from the sample by using a moisture meter manufactured by HIRANUMA Co., Ltd. by a Karl-Fischer method.

### (5) Pyrolysis Resistance

In the specimen-producing step, a specimen was produced so that the thickness of the cured coating was 30 µm ± 10 µm. The obtained specimen was finely cut to prepare a sample. On the sample, a temperature at which the weight was reduced by 5% under an air atmosphere at a heating rate of 10°C/min was measured by using a thermogravimeter (manufactured by Hitachi High-Tech Science Corporation, thermogravimeter "STA 7200RV") to evaluate the temperature as a pyrolysis resistant temperature (Td5) [°C].

### (6) Insulation Breakdown Voltage

In the specimen-producing step, the polyamic acid composition prepared in Examples 1 to 2 and Comparative Examples 1 to 3 was uniformly applied onto a copper-clad laminate (ESPANEX) by using a bar coater so that the thickness of the cured coating was 30 µm ± 10 µm, and then the thermal curing step from the aforementioned preliminary drying to the post curing was performed to form a cured coating. Thereafter, on the formed cured coating, an insulation breakdown voltage was evaluated under conditions of a set voltage of 12 kV, a set current of 9999 µA, and a pressurizing rate of 500 V/sec by using a withstand voltage tester manufactured by Keisoku Giken Co., Ltd.

As shown in Table 1, in both of Examples 1 to 2, which used the polyamic acid obtained by the polyaddition reaction between the ester-type acid dianhydride and the diamine containing the dimer diamine at a molar ratio of 0.3 or more relative to the entirety of the diamine component, the dielectric constant, the dielectric loss tangent, and the water-absorption rate were low, and the polyimide exhibiting the low dielectric property and the low hygroscopic property was produced.

Meanwhile, Comparative Example 1, which used the tetracarboxylic dianhydride as the acid dianhydride instead of the ester-type acid dianhydride, exhibited a higher water-absorption rate than Examples 1 to 2, and failed to produce the polyimide exhibiting the desired low hygroscopic property. Note that Comparative Example 1 exhibited a high absorption property, and thereby the dielectric constant and the dielectric loss tangent after heating under an atmosphere of temperature of 85°C and humidity of 80 RH% for 200 hours were not measured.

Both of Comparative Examples 2 and 3, which had a molar ratio of the dimer diamine of less than 0.3 relative to the entirety of the diamine component, exhibited high dielectric constant and dielectric loss tangent, and failed to produce the polyimide exhibiting the desired low dielectric property. In particular, Comparative Example 3, which contained no dimer diamine as the diamine, exhibited higher dielectric constant and dielectric loss tangent than Examples 1 to 2 and Comparative Examples 1 to 2, further exhibited dehydrative behavior due to incomplete thermal imidization, and exhibited fast reduction in weight and poor pyrolysis resistance. Note that Comparative Examples 2 and 3 exhibited high dielectric constant and dielectric loss tangent, and thereby the absorption property was not measured. In Comparative Examples 2, the dielectric constant and the dielectric loss tangent after heating under an atmosphere of temperature of 85°C and humidity of 80 RH% for 200 hours were not measured.

The polyamic acid of the present invention can form the polyimide exhibiting not only good insulativity and mechanical strength but also the low dielectric property and the low hygroscopic property, and thereby the polyimide film produced by using such a polyimide has high utility value as, for example, an insulative substrate of a printed circuit board, specifically a base film of a flexible printed circuit.

## Claims

1. A polyamic acid that is a product obtained by polyaddition reaction between an ester-type acid dianhydride (A) and at least two diamines (B), wherein
a dimer diamine (B1) is contained at a molar ratio of 0.3 or more relative to an entirety of the diamine component.

2. The polyamic acid according to claim 1, wherein the ester-type acid dianhydride (A) has a structure represented by the following formula (1): 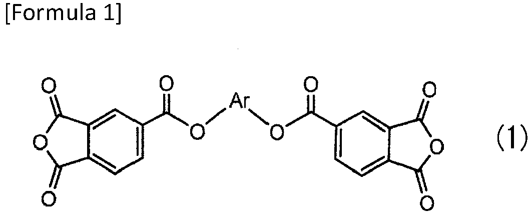 wherein Ar represents a substituted or unsubstituted arylene group.

3. The polyamic acid according to claim 1 or 2, wherein the at least two diamines (B) comprise an aromatic diamine (B2).

4. A polyamic acid composition comprising:
the polyamic acid according to any one of claims 1 to 3; and
an organic solvent (C).

5. A polyimide obtained by imidizing the polyamic acid according to any one of claims 1 to 4.

6. A polyimide film, comprising the polyimide according to claim 5.

7. A printed circuit board, comprising the polyimide film according to claim 6.
